# EUROPÄISCHE PATENTSCHRIFT

(11) **EP 2 982 014 B1**
(45) Veröffentlichungstag und Bekanntmachung des Hinweises auf die Patenterteilung: **02.08.2017**
(21) Anmeldenummer: 14716271.3
(22) Anmeldetag: 03.04.2014
(51) Int. Cl.: H02B 1/56, F24F 13/08, H05K 5/02

(54) **ERREICHUNG EINER SCHUTZART FÜR ELEKTRISCHE UND ELEKTRONISCHE GERÄTE, INSBESONDERE FÜR SCHALTSCHRÄNKE**
ACHIEVING A PROTECTION RATING FOR ELECTRIC AND ELECTRONIC DEVICES, IN PARTICULAR SWITCHGEAR CABINETS
RÉALISATION D'UN TYPE DE PROTECTION POUR APPAREILS ÉLECTRIQUES ET ÉLECTRONIQUES, EN PARTICULIER POUR ARMOIRES DE DISTRIBUTION

(30) Priorität: 05.04.2013 DE 102013103444
(43) Veröffentlichungstag der Anmeldung: 10.02.2016
(73) Patentinhaber: Eaton Industries (Austria) GmbH, 3943 Schrems (AT)
(72) Erfinder: WEIGL, Franz, A-3961 Waldenstein (AT); REUBERGER, Georg, A-3931 Schweiggers (AT); SCHERZER, Martin, A-3873 Brand (AT)
(74) Vertreter: Eaton IP Group EMEA
(86) Internationale Anmeldenummer: PCT/EP2014/056739
(87) Internationale Veröffentlichungsnummer: WO 2014/161962

(56) Entgegenhaltungen:
- EP-A1- 1 303 015
- EP-A2- 1 026 932
- WO-A1-2005/055384
- DE-A1- 10 038 821
- DE-A1- 19 925 439
- DE-U1- 8 130 651
- DE-U1- 29 623 678

## Beschreibung

### TECHNISCHES GEBIET

Die Erfindung betrifft einen Schaltschrank, umfassend eine Gehäusewand mit darin angeordneten Kiemen und/oder Lamellen.

### STAND DER TECHNIK

Ein solcher Schaltschrank ist aus dem Stand der Technik grundsätzlich bekannt. Dabei dienen die Kiemen und/oder Lamellen in der Regel der Belüftung von im Schaltschrank angeordneten Komponenten.

Beispielsweise offenbart die DE 100 38 821 A1 dazu ein Lüftungsgitter für ein Gehäuse mit elektrischen Bauelementen und mit wenigstens einem perforierten Lufteintrittsbereich, wobei das Lüftungsgitter ein Lamellenoberteil und ein Lüftungsgitterunterteil aufweist. Ein Boden des Lüftungsgitterunterteils weist eine zum perforierten Lufteintrittsbereich des Gehäuses korrespondierende Perforation und sein Rahmen mehrere Rasthaken auf, die ebenfalls mit der genannten Perforation korrespondieren. Zudem weist das Lamellenoberteil ebenfalls Rasthaken auf, die mit dem Lüftungsgitterunterteil korrespondieren. Mit Hilfe des Lüftungsgitters kann der Schmutzgrad stufenweise erhöht werden, ohne dass Änderungen am Gehäuse vorgenommen werden müssen.

Nachteilig ist daran, dass die Wärme aufgrund der Anordnung des Lufteintrittsbereichs nur unzureichend abtransportiert werden kann. Die bekannte Anordnung eignet sich daher eher nur für Schaltschränke, in denen elektrische Geräte mit vergleichsweise niedriger (Verlust) Leistung angeordnet sind.

Weiterhin offenbart die WO 2005/055384 A1 einen Schaltschrank, dessen Tür mit Kiemen und einem dazu benachbart angeordneten Filter ausgestattet ist. Der Schaltschrank weist zudem eine Dachauslassöffnung auf. Die EP 1 303 015 A1 offenbart außerdem einen Schaltschrank mit Lüftungsöffnungen in der Schaltschranktür, die EP 1 026 932 A2 einen Schaltschrank mit anbaubaren Lüftungsmodulen, die einen Filter aufweisen können, die DE 81 30 651 U1 und die DE 296 23 678 U1 allgemein einen belüftbaren Schaltschrank, die DE 199 25 439 A1 allgemein einen Lüfter für einen Schaltschrank, bei dem lamellenartige Öffnungen mit einem Filter und einem Gitter kombiniert werden, und die DE 100 38 821 A1 allgemein ein Lüftungsgitter mit lamellenartigen Öffnungen, das mit einem Filter kombiniert werden kann.

### OFFENBARUNG DER ERFINDUNG

Eine Aufgabe der Erfindung ist es nun, einen verbesserten Schaltschrank anzugeben. Insbesondere soll der Wärmeabtransport unter Beibehaltung einer Schutzklasse verbessert werden.

Die Erfindung wird durch einen Schaltschrank gelöst, umfassend
- eine Tür an einer Vorderseite des Schaltschranks mit darin angeordneten Kiemen und/oder Lamellen sowie einem zu den Kiemen / Lamellen benachbart angeordnetem, ersten Gitter, welche eine Schutzart bis zu IP43 sicherstellen,
- eine Rückwand mit darin angeordneten Kiemen und/oder Lamellen sowie einem zu den Kiemen / Lamellen benachbart angeordnetem, zweiten Gitter, welche eine Schutzart bis zu IP43 sicherstellen, und
- eine Gehäusewand mit darin angeordneten Schlitzen, Kiemen und/oder Lamellen und einem über die Gehäusewand vorspringenden Dach sowie einem zu den Schlitzen / Kiemen / Lamellen benachbart angeordnetem, dritten Gitter, welche eine Schutzart bis zu IP43 sicherstellen, wobei
- eine Maschenweite des ersten/zweiten/dritten Gitters kleiner ist als der abzuhaltende Fremdkörper der jeweiligen Schutzklasse und a) die Kiemen / Lamellen von oben innen nach unten außen ausgerichtet sind und in der Eindringrichtung des Wassers der jeweiligen Schutzklasse einander überlappen beziehungsweise b) das Dach eine benachbart zum Gitter angeordnete Öffnung im Gehäuse in der Eindringrichtung des Wassers der jeweiligen Schutzklasse überdeckt, und wobei
- das erste Gitter an der Tür und das dritte Gitter im Dachbereich innenseitig und das zweite Gitter an der Rückwand außenseitig angeordnet ist.

Durch die vorgenommenen Maßnahmen wird eine gute Durchlüftung des Schaltschranks erreicht und der Wärmeabtransport aus dem Schaltschrank wesentlich verbessert, da warme Abluft im Dachbereich entweichen und Frischluft im unteren Bereich des Schaltschranks zuströmen kann. Dennoch wird für den gesamten Schaltschrank wirksamer Schutz gegen elektrischen Schlag sichergestellt. Zudem kann das Gitter gut demontiert werden, beispielsweise um dieses zu reinigen.

Durch die Schutzart wird die Eignung elektrischer und elektronischer Geräte für den Betrieb unter bestimmten Umweltbedingungen angegeben. Dazu existiert ein IPxx-Code, dessen erste Ziffer den Eindringschutz gegen Fremdkörper und dessen zweite Ziffer den Eindringschutz gegen Wasser angibt. Steigende Ziffern bedeuten dabei jeweils erhöhten Schutz. Beispielsweise bedeutet die Schutzklasse IP43, dass ein Eindringen von Fremdkörpern ab einem Durchmesser von 1mm und gegen fallendes Sprühwasser bis 60° gegen die Senkrechte gegeben ist. Diese Klassifizierung der Schutzart ist durch verschiedenen Normen geregelt, beispielsweise durch die DIN EN 60529, DIN 40 050-9 und durch die ISO 20653.

Durch die oben angegebenen Maßnahmen wird nun sowohl wirksamer Schutz gegen Eindringen von Festkörpern also auch Eindringschutz gegen Wasser erzielt, wobei das Gitter im Wesentlichen den Schutz gegen das Eindringen eines Festkörpers und die Kiemen/Lamellen beziehungsweise das Dach im Wesentlichen den Schutz gegen das Eindringen von Wasser bewirken.

Unter "Lamellen" sind im Rahmen der Erfindung längliche ebene Plättchen oder plättchenförmige Bereiche zu verstehen, die entweder an einer ihrer Längskanten oder an zwei Punkten auf je einer ihrer Querkanten mit einer Wand-ähnlichen Struktur (insbesondere einer Gehäusewand) verbunden sind.

Die im Rahmen der Erfindung verwendeten "Kiemen" sind ähnlich wie Lamellen aufgebaut, sind aber im Gegensatz dazu sowohl an einer ihrer Längskanten als auch entlang ihrer Querkanten mit einer Wand-ähnlichen Struktur (insbesondere einer Gehäusewand) verbunden. Bleche mit integrierten Kiemen werden auch "Kiemenbleche" genannt und sind grundsätzlich bekannt.

"Benachbart" bedeutet in Bezug auf die Kombination der Kiemen/Lamellen mit dem Gitter im Rahmen der Erfindung, dass einströmende Luft direkt nach dem Passieren der Kiemen/Lamellen das Gitter passiert oder umgekehrt. "Benachbart" bedeutet nicht zwangsläufig "einander berührend" und auch nicht "parallel". Folglich kann das zu den Kiemen/Lamellen benachbarte Gitter auch von diesem beabstandet sein und insbesondere auch einen Winkel von 90° zu diesem einschließen.

Weitere vorteilhafte Ausgestaltungen und Weiterbildungen der Erfindung ergeben sich aus den Unteransprüchen sowie aus der Beschreibung in Zusammenschau mit den Figuren.

Günstig ist es, wenn das Gitter in oder auf einem Gitterhalter angeordnet ist. Auf diese Weise ist das Gitter leichter handhabbar. Beschädigungen und insbesondere unerwünschte Verformungen des Gitters, welche beim Manipulieren desselben entstehen können, werden dadurch weitgehend vermieden.

Vorteilhaft ist es, wenn der Schaltschrank eine schräg zur Gehäusewand verlaufende Haltestruktur aufweist, entlang der das Gitter / der Gitterhalter und die Gehäusewand relativ zueinander verschiebbar sind. Beispielsweise kann dazu der Gitterhalter eine schräge Nut oder Ausnehmung aufweisen, in die bei der Montage des Gitterhalters auf der Gehäusewand ein mit dieser Gehäusewand verbundener Stift eingreift. Dadurch wird der Gitterhalter bei der Montage gegen das Gehäuse gedrückt. Vorzugsweise ist der verbleibende Spalt zwischen Gitter/Gitterhalter und Gehäuse kleiner als der abzuhaltende Fremdkörper der jeweiligen Schutzklasse. Denkbar ist natürlich auch, dass die Nut oder Ausnehmung gehäuseseitig und der eingreifende Stift auf dem Gitterhalter angeordnet ist. Denkbar sind natürlich auch andere Befestigungsmethoden. Beispielsweise kann der Gitterhalter auf das Gehäuse auch aufgeschnappt oder an dieses angeschraubt sein.

Vorteilhaft ist es weiterhin, wenn das Gitter beziehungsweise der Gitterhalter mit einer Schraube gesichert/geerdet ist. Dadurch wird der Gitterhalter vor Heraus- oder Herabfallen gesichert, beziehungsweise wird durch eine Erdung auch das Führen einer gefährlichen Spannung verhindert.

Günstig ist es schließlich auch, wenn die Gehäusewand im Bereich der Kiemen und/oder Lamellen durch ein gesondertes Gehäusebauteil gebildet ist. Dadurch kann die Herstellung von Gehäusewänden unter Umständen vereinfacht oder auch vereinheitlicht werden, wenn mehrere verschiedene Schaltschränke mit Hilfe eines modularen Systems aus Kiemen-/Lamelleneinsätzen und Gehäusewänden aufgebaut werden.

### KURZE BESCHREIBUNG DER FIGUREN

Die vorliegende Erfindung wird nachfolgend anhand der in den schematischen Figuren der Zeichnung angegebenen Ausführungsbeispiele näher erläutert. Es zeigen dabei:
- Fig. 1: eine Detailansicht einer beispielhaften Schaltschrankrückwand mit kiemenartigen Ausschnitten und abgenommenem Gitter;
- Fig. 2: die Schaltschrankrückwand aus Fig. 1 mit montiertem Gitter und zusätzlichen Detaildarstellungen;
- Fig. 3: eine beispielhafte Schaltschranktür mit kiemenartigen Ausschnitten von außen;
- Fig. 4: die Schaltschranktür aus Fig. 3 mit montiertem Gitter/Gitterhalter von innen;
- Fig. 5: den Oberteil eines beispielhaften Schaltschranks mit einem Lüftungsrahmen und einem vorspringenden Dach;
- Fig. 6: den Oberteil aus Fig. 5 mit montiertem Gitter/Gitterhalter von schräg unten;
- Fig. 7: einen beispielhaften Schaltschrank in Schrägansicht;
- Fig. 8: eine in der Gehäusewand angeordnete Lamelle in Detailansicht und
- Fig. 9: eine in der Gehäusewand angeordnete Kieme in Detailansicht.

### DETAILIERTE BESCHREIBUNG DER ERFINDUNG

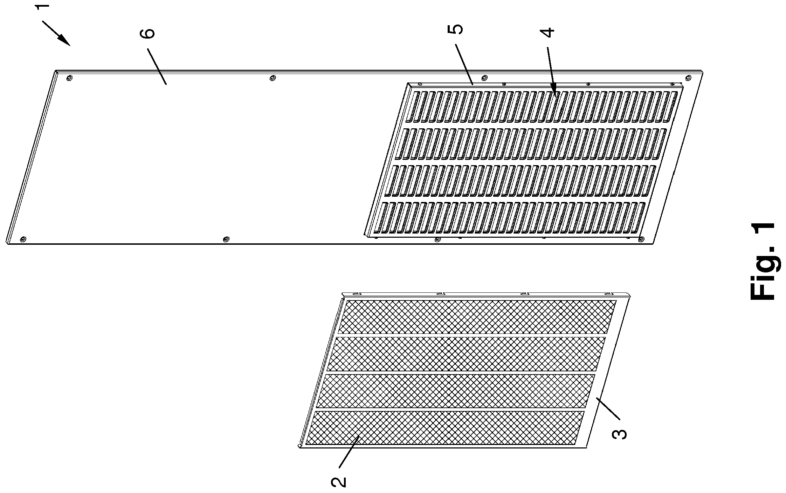

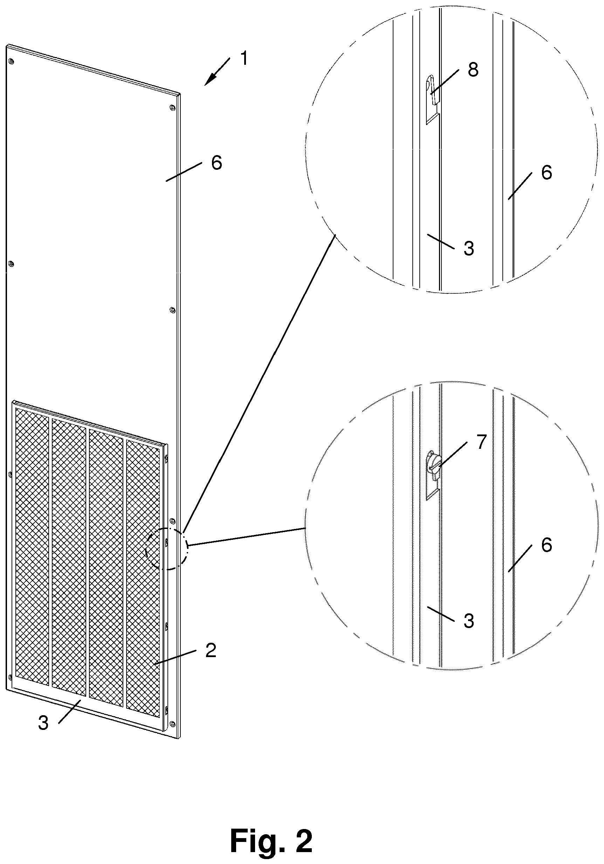

Die Fig. 1 zeigt eine Rückwand 1 eines Schaltschranks von der Außenseite mit abgenommenem Gitter 2 beziehungsweise Gitterhalter 3. Die Fig. 2 zeigt die Rückwand 1 aus Fig. 1 mit montiertem Gitter 2 beziehungsweise Gitterhalter 3, sowie Detaildarstellungen desselben.

Die Rückwand 1 weist kiemenartige Ausschnitte 4 auf, die in dem dargestellten Beispiel in einem gesonderten Gehäusebauteil 5 angeordnet sind, das in die Gehäusewand 6 eingesetzt ist. Selbstverständlich könnten die Kiemen 4 aber auch direkt in die Gehäusewand 6 eingearbeitet sein. Im Bereich der Kiemen 4 ist ein vom Gehäusebauteil 5 umfasster Halterahmen mit mehreren Schrauben 7 angeordnet, der/die zum Halten des Gitterhalters 3 dient/dienen.

Der Gitterhalter 3 weist L-förmige Schlitze 8 auf, die einen schräg zur Ebene des Gitterhalters 3 verlaufenden Abschnitt aufweisen. Mit Hilfe dieser L-förmigen Schlitze 8, in welche die Schrauben 7 eingreifen, kann der Gitterhalter 3 und somit das Gitter 2 auf dem Halterahmen 5 befestigt werden. Der Gitterhalter 3 weist also eine schräg zur Gehäusewand 6 verlaufende Haltestruktur auf, entlang der das Gitter 2 / der Gitterhalter 3 und die Gehäusewand 6 relativ zueinander verschiebbar sind. Die Fig. 2 zeigt entsprechende Detaildarstellungen des L-förmigen Schlitzes 8, einmal mit eingreifender Schraube 7 (unten) und einmal ohne Schraube (oben).

Im gezeigten Beispiel sind die L-förmigen Schlitze 8 im Gitterhalter 3 und die Schrauben 7 am Halterahmen 5 angeordnet. Denkbar wäre gleichwertig aber auch, dass die die Schrauben 7 im Gitterhalter 3 und die L-förmigen Schlitze 8 im Halterahmen 5 angeordnet sind.

Durch die Gehäusewand 6 mit den darin angeordneten Kiemen 4 und dem benachbart zu den Kiemen 4 angeordneten Gitter 2 wird eine Schutzart bis zu IP43 sichergestellt. Eine Maschenweite des Gitters 2 ist dabei kleiner als der abzuhaltende Fremdkörper der jeweiligen Schutzklasse, und die Kiemen 4 sind von oben innen nach unten außen ausgerichtet und überlappen einander in der Eindringrichtung des Wassers der jeweiligen Schutzklasse.

Über die Schrauben 7 am Halterahmen 5 kann auch eine Erdung des Gitterhalters 3 beziehungsweise des Gitters 2 erfolgen. Ist dies nicht möglich oder nicht erwünscht, so kann die Erdung in an sich bekannter Weise auch über eine gesonderte Schraube erfolgen.

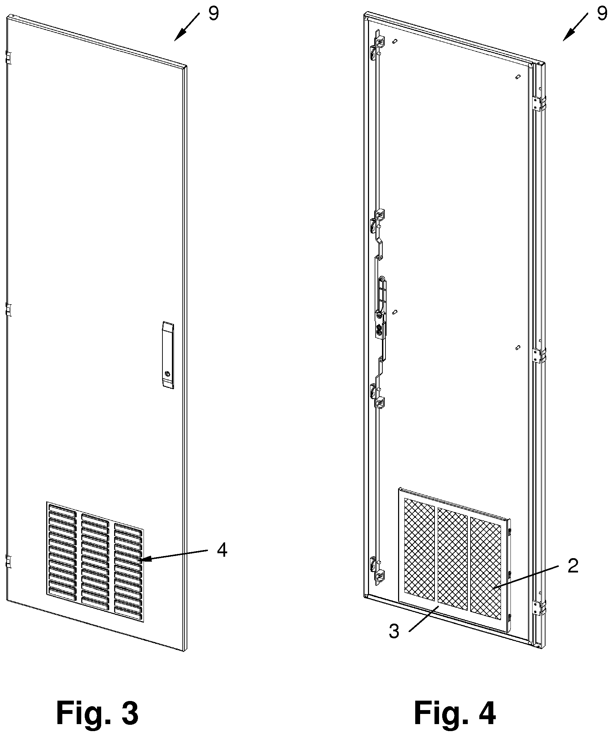

Die Fig. 3 zeigt nun eine Schaltschranktür 9 von außen mit den gut sichtbaren Kiemen 4. Benachbart zu den Kiemen 4 ist auf der Türinnenseite wiederum ein Gitterhalter 3 mit einem Gitter 2 angeordnet so wie dies in Fig. 4 gezeigt ist.

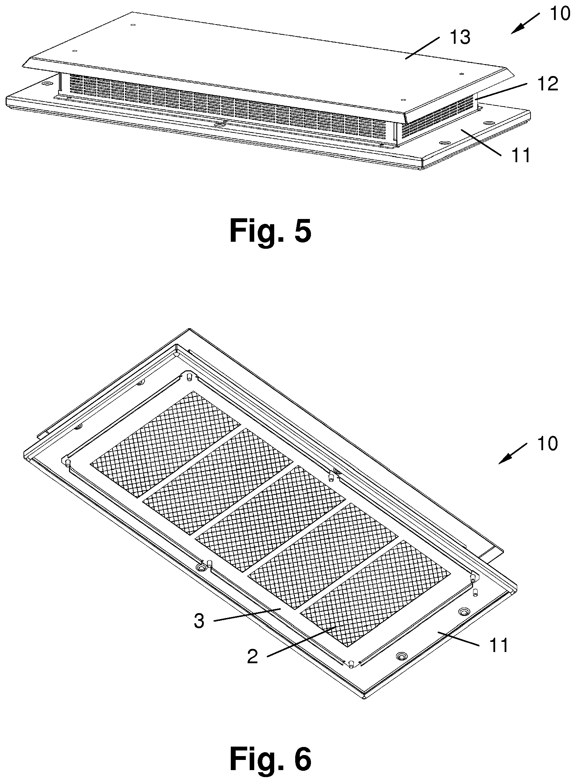

Fig. 5 zeigt nun von schräg oben den Oberteil 10 eines Schaltschranks umfassend ein Deckblech 11, einen Lüftungsrahmen 12, welcher den gegenüber der Kontur des Schaltschranks nach innen versetzen Teil einer Gehäusewand 6 bildet, sowie ein über den Lüftungsrahmen 12 / die Gehäusewand 6 vorspringendes Dach 13. Fig. 6 zeigt dieselbe Anordnung von schräg unten, wobei ein von unten auf das Deckblech 11 montierter Gitterhalter 3 mit einem Gitter 2 sichtbar ist. Im Lüftungsrahmen 12 sind in diesem Fall lediglich Schlitze angeordnet, da der Eindringschutz gegen Wasser durch das vorspringende Dach 13 gebildet ist. Das Dach 13 überdeckt die Öffnung in dem Lüftungsrahmen 12 / der Gehäusewand 6 dabei in der Eindringrichtung des Wassers der jeweiligen Schutzklasse. Dadurch wird ebenfalls eine Schutzart von bis zu IP43 sichergestellt.

Denkbar ist auch, dass im senkrechten Teil des Gehäuses oberhalb der Kiemen 4 ein die Gehäusewand 6 überragendes (Vor)dach angeordnet ist, beispielsweise auf der Außenseite der in der Fig. 6 dargestellten Tür 9.

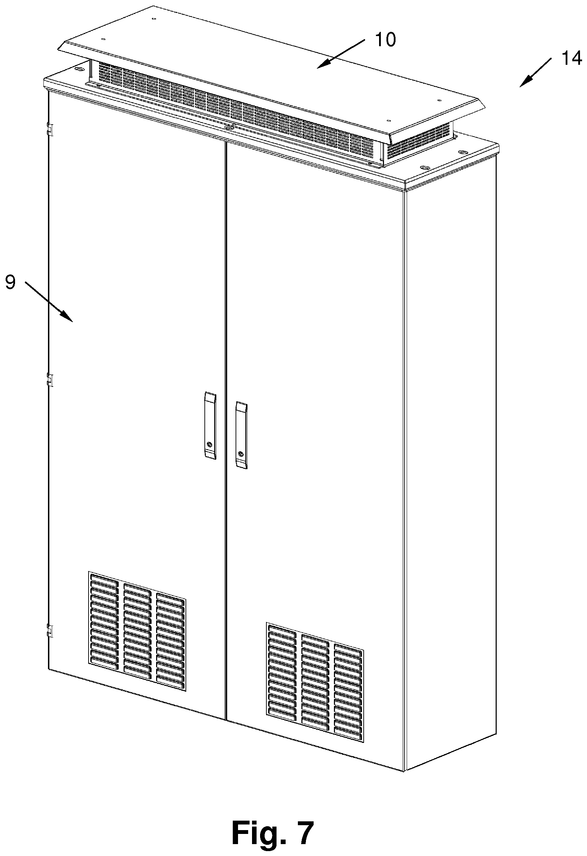

Durch die in den Figuren 1 bis 6 dargestellte Kombination von Gehäusebauteilen entsteht ein Schaltschrank 14, welcher in Fig. 7 dargestellt ist. Bei diesem ist eine Kombination von Kiemen/Lamellen 4 mit einem Gitter 2, welche eine Schutzart bis zu IP43 sicherstellt, an einer Tür 9 an einer Vorderseite des Schaltschranks 14, an dessen Rückwand 1 und in dessen Dachbereich 10 angeordnet. Die Gitter 2 / Gitterhalter 3 sind an der Tür 9 und im Dachbereich 10 innenseitig und an der Rückwand 1 außenseitig angeordnet.

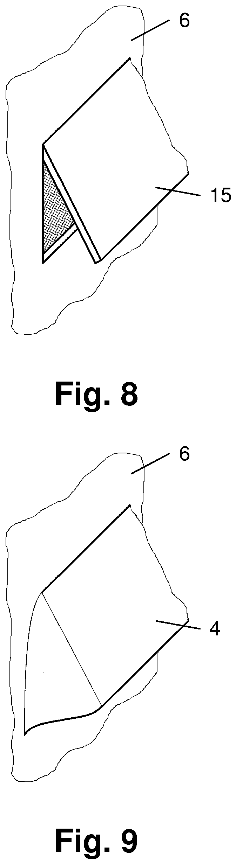

An dieser Stelle wird auch angemerkt, dass anstelle von Kiemen 4 in der Gehäusewand 6 auch Lamellen eingesetzt werden können. Die Figuren 8 und 9 sollen dazu den Unterschied nochmals verdeutlichen. Während die in Fig. 8 dargestellte beispielhafte Lamelle 15 seitlich offen ist, ist die in der Fig. 9 dargestellte Kieme 4 auch seitlich zu.

Die Lamelle 15 ist nicht notwendigerweise an der Oberkante mit der Gehäusewand 6 verbunden, so wie dies in Fig. 8 dargestellt ist, sondern kann auch seitlich an zwei Punkten mit dieser verbunden sein, sodass oberhalb und unterhalb der Lamelle 15 ein Durchbruch der Gehäusewand 6 angeordnet ist.

Weiterhin kann die Kieme 4 um 180° um ihre Längsachse gedreht an der Innenseite der Gehäusewand 6 angeordnet sein. Die Öffnung ist dann innen oben angeordnet, das Wasser fließt aber dennoch nach außen ab. Eine solche Anordnung ist insbesondere dann zweckmäßig, wenn der Gitterhalter 3 bündig an der Außenseite der Gehäusewand 6 angeordnet werden soll.

Weiterhin kann der in den Figuren 5 und 6 dargestellte Lüftungsrahmen 12 ebenfalls Kiemen 4 und/oder Lamellen 15 anstelle von einfachen Lüftungsschlitzen aufweisen. Generell kann durch die Kombination der Kiemen 4 / der Lamellen 15 / des Dachs 13 mit dem Gitter 2 eine Schutzart bis zu IP43 sichergestellt werden, wobei das Gitter 2 im Wesentlichen den Schutz gegen das Eindringen eines Festkörpers und die Kiemen 4 / die Lamellen 15 im Wesentlichen den Schutz gegen das Eindringen von Wasser bewirken. Denkbar wäre aber auch, das Gitter 2 mit einem Filter zu kombinieren. Selbstverständlich kann das Gitter 2 auch auf andere Weise als mit einem Gitterhalter 3 am Gehäuse 6 befestigt werden, beispielsweise mit Klemmleisten, die mit dem Gehäuse 6 verschraubt werden.

Weiterhin wird angemerkt, dass der in den Figuren 1 bis 7 dargestellte Schaltschrank 14 nur ein beispielhaftes konkretes Beispiel darstellt, bei dem die Kombination aus Gitter 2 und Kiemen 4 / Lamellen 15 / Dach 12 zur Sicherstellung einer bestimmten Schutzart verwendet werden kann. Die genannte Kombination kann aber auch bei ähnliche elektrischen oder elektronischen Geräteschranken eingesetzt werden, bei denen eine bestimmte Schutzart sichergestellt werden soll.

Abschließend wird angemerkt, dass die in den Figuren 1 bis 9 dargestellten Anordnungen nicht notwendigerweise maßstäblich dargestellt sind und daher auch andere Proportionen aufweisen können. Weiterhin können die Anordnungen auch mehr oder weniger Bauteile als dargestellt umfassen. Lageangaben (z.B. "oben", "unten", "links", "rechts", etc.) sind auf die jeweils beschriebene Figur bezogen und sind bei einer Lageänderung sinngemäß an die neue Lage anzupassen.

## Patentansprüche

1. Schaltschrank (14), umfassend
- eine Tür (9) an einer Vorderseite des Schaltschranks (14) mit darin angeordneten Kiemen (4) und/oder Lamellen (15) sowie einem zu den Kiemen (4) / Lamellen (15) benachbart angeordnetem, ersten Gitter (2), welche eine Schutzart bis zu IP43 sicherstellen,
**gekennzeichnet durch**
- eine Rückwand (1) mit darin angeordneten Kiemen (4) und/oder Lamellen (15) sowie einem zu den Kiemen (4) / Lamellen (15) benachbart angeordnetem, zweiten Gitter (2), welche eine Schutzart bis zu IP43 sicherstellen, und
- eine Gehäusewand (6) mit darin angeordneten Schlitzen, Kiemen (4) und/oder Lamellen (15) und einem über die Gehäusewand (6, 12) vorspringenden Dach (13) sowie einem zu den Schlitzen / Kiemen (4) / Lamellen (15) benachbart angeordnetem, dritten Gitter (2), welche eine Schutzart bis zu IP43 sicherstellen, wobei
- eine Maschenweite des ersten/zweiten/dritten Gitters (2) kleiner ist als der abzuhaltende Fremdkörper der jeweiligen Schutzklasse und a) die Kiemen (4) / Lamellen (15) von oben innen nach unten außen ausgerichtet sind und in der Eindringrichtung des Wassers der jeweiligen Schutzklasse einander überlappen und b) das Dach (13) eine benachbart zum Gitter (2) angeordnete Öffnung im Gehäuse (6, 12) in der Eindringrichtung des Wassers der jeweiligen Schutzklasse überdeckt, und wobei
- das erste Gitter (2) an der Tür (9) und das dritte Gitter (2) im Dachbereich (10) innenseitig und das zweite Gitter (2) an der Rückwand (1) außenseitig angeordnet ist.

2. Schaltschrank (14) nach Anspruch 1, **dadurch gekennzeichnet, dass** das Gitter (2) in oder auf einem Gitterhalter (3) angeordnet ist.

3. Schaltschrank (14) nach einem der Ansprüche 1 oder 2, **gekennzeichnet durch** eine schräg zur Gehäusewand (6) verlaufende Haltestruktur (7), entlang der das Gitter (2) / der Gitterhalter (3) und die Gehäusewand (6) relativ zueinander verschiebbar sind.

## Claims

1. Switchgear cabinet (14), comprising
- a door (9) at a front side of the switchgear cabinet (14) with gills (4) and/or slats (15) arranged therein as well as a first grille (2) arranged adjacent to the gills (4)/slats (15), which assure a protection rating up to IP43,
**characterised by**
- a back wall (1) with gills (4) and/or slats (15) arranged therein as well as a second grille (2) arranged adjacent to the gills (4)/slats (15), which assure a protection rating up to IP43, and
- a housing wall (6) with slots, gills (4) arranged therein and/or slats (15) and a roof (13) projecting beyond the housing wall (6, 12) as well as a third grille (2) arranged adjacent to the slots/gills (4)/slats (15), which assure a protection rating up to IP43, wherein
- a mesh size of the first/second/third grille (2) is smaller than the foreign object of each respective protection class which is to be kept out and a) the gills (4)/slats (15) are oriented from the top inside to the bottom outside and overlap in the direction of water ingress of each respective protection class, and b) the roof (13) covers an opening in the housing (6, 12) adjacent to the grille (2) in the direction of water ingress of each respective protection class, and wherein
- the first grille (2) is arranged at the door (9) and the third grille (2) is arranged on the inside in the roof area (10) and the second grille (2) is arranged on the outside at the back wall (1).

2. Switchgear cabinet (14) according to claim 1, **characterised in that** the grille (2) is arranged in or on a grille holder (3).

3. Switchgear cabinet (14) according to any one of claims 1 or 2, **characterised by** a holding structure (7) running at an angle to the housing wall (6), along which the grille (2)/the grille holder (3) and the housing wall (6) are moveable relative to one another.

## Revendications

1. Armoire de distribution (14), comprenant ;
- une porte (9) au niveau d'un côté avant de l'armoire de distribution (14) avec des lames (4) et/ou volets (15) agencés à l'intérieur ainsi qu'une première grille (2) agencée de manière adjacente aux lames (4)/volets (15), lesquels garantissent un type de protection jusqu'à IP43,
**caractérisée par**
- une paroi arrière (1) avec des lames (4) et/ou volets (15) agencés à l'intérieur ainsi qu'une deuxième grille (2) agencée de manière adjacente aux lames (4)/volets (15), lesquels garantissent un type de protection jusqu'à IP43, et
- une paroi de boîtier (6) avec des fentes, lames (4) et/ou volets (15) agencés à l'intérieur et un toit (13) en saillie au-dessus de la paroi de boîtier (6, 12) ainsi qu'une troisième grille (2) agencée de manière adjacente aux fentes/lames (4)/volets (15), lesquels garantissent un type de protection jusqu'à IP43, dans laquelle
- un maillage de la première/deuxième/troisième grille (2) est inférieur au corps étranger de la classe de protection respective à retenir et a) les lames (4)/volets (15) sont orientés depuis le haut à l'intérieur vers le bas à l'extérieur et se chevauchent les unes les autres dans la direction de pénétration de l'eau de la classe de protection respective et b) le toit (13) recouvre une ouverture agencée de manière adjacente à la grille (2) dans le boîtier (6, 12) dans la direction de pénétration de l'eau de la classe de protection respective, et dans laquelle
- la première grille (2) est agencée au niveau de la porte (9) et la troisième grille (2) sur le côté intérieur dans la zone de toit (10) et la deuxième grille (2) sur le côté extérieur au niveau de la paroi arrière (1).

2. Armoire de distribution (14) selon la revendication 1, **caractérisée en ce que** la grille (2) est agencée dans ou sur un support de grille (3).

3. Armoire de distribution (14) selon l'une quelconque des revendications 1 ou 2, **caractérisée par** une structure de support (7) s'étendant de manière oblique par rapport à la paroi de boîtier (6), le long de laquelle la grille (2)/le support de grille (3) et la paroi de boîtier (6) peuvent être déplacés de manière coulissante l'un par rapport à l'autre.
